# FASCICULE DE BREVET EUROPEEN

(11) **EP 1 005 089 B1**
(45) Date de publication et mention de la délivrance du brevet: **19.12.2007**
(21) Numéro de dépôt: 99402889.2
(22) Date de dépôt: 22.11.1999
(51) Int. Cl.: H01L 25/07

(54) **Dispositif électronique de puissance**
Leistungshalbleiter
Power Semiconductor Device

(30) Priorité: 27.11.1998 FR 9815157
(43) Date de publication de la demande: 31.05.2000
(73) Titulaire: ALSTOM Holdings, 92300 Levallois-Perret (FR)
(72) Inventeur: Mermet-Guyennet, Michel, 65 390 Aurensan (FR)
(74) Mandataire: Jacobson, Claude

(56) Documents cités:
- WO-A-98/15005
- DE-A- 4 403 996
- US-A- 5 532 512

## Description

La présente invention concerne un dispositif électronique de puissance.

De manière habituelle, les dispositifs électroniques de puissance, qui sont en particulier destinés à la traction ferroviaire, comprennent une embase conductrice réalisée par exemple en cuivre, sur laquelle sont rapportées des structures composites de type conducteur-isolant-conducteur assumant à la fois une fonction de transfert thermique et d'isolation électrique. La couche supérieure conductrice de chacune de ces structures composites constitue une semelle sur laquelle sont placés des diodes et des transistors bipolaires à grille isolée dits IGBT, suivant une disposition variant en fonction de la nature du dispositif électronique considéré. La fixation de ces circuits semi-conducteurs de puissance est assurée par exemple par soudure tendre d'étain-plomb ou d'étain-plomb-argent.

Ces diodes et ces IGBT sont en outre recouverts, sur leur face libre, par un ou plusieurs plots de connexion, sur chacun desquels sont soudés plusieurs fils d'aluminium présentant typiquement un diamètre de 380 à 500 microns. Chacun de ces fils est soudé, à son autre extrémité, sur la semelle conductrice supérieure de l'une des structures composites formant le bras d'onduleur.

Ce mode de réalisation connu présente cependant certains inconvénients. En effet, l'exécution de tels dispositifs électroniques de puissance se révèle complexe, dans la mesure où il est fait appel à un nombre très élevé de fils d'aluminium. De plus, la surface globale de ces dispositifs de puissance est relativement importante, ce qui contribue à augmenter également le volume global du dispositif une fois assemblé, et se trouve également à l'origine de phénomènes d'inductances parasites préjudiciables au bon fonctionnement électrique.

De l'état de la technique est divulgué dans US-A-5,532,512 et dans WO 98/150005. Ces documents décrivent chacun un empilement de composants électroniques.

L'invention se propose de réaliser un dispositif électronique de puissance permettant de pallier les inconvénients de l'art antérieur évoqué ci-dessus. A cet effet, elle a pour objet un dispositif électronique conforme à la revendication 1.

D'autres caractéristiques de l'invention apparaissent dans les revendications dépendantes.

L'invention va être décrite ci-dessous, en référence aux dessins annexés, donnés uniquement à titre d'exemples non limitatifs et dans lesquels :
- la figure 1 est une vue en perspective avec arrachement illustrant les différents éléments constitutifs d'un bras d'onduleur conforme à l'invention ;
- la figure 2 est une vue en coupe axiale du bras d'onduleur ainsi formé ;
- la figure 3 est une vue en coupe partielle selon la ligne III-III à la figure 2 ;
- la figure 4 est une vue schématique illustrant la fixation d'une barre conductrice sur une diode du bras d'onduleur de l'invention ;et
- la figure 5 est un schéma de principe du bras d'onduleur des figures précédentes.

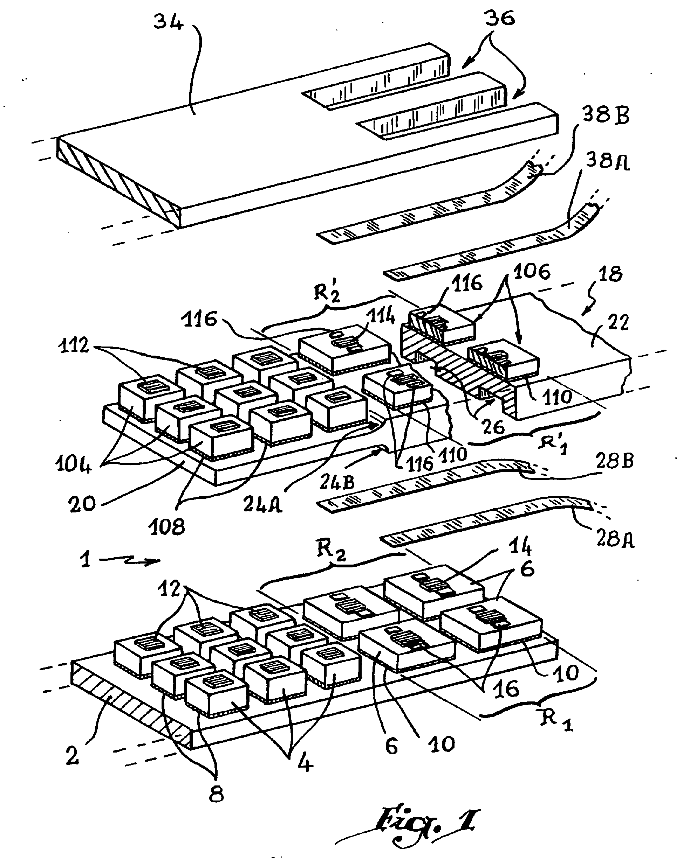

La figure 1 illustre la fabrication d'un bras d'onduleur conforme à l'invention, désigné dans son ensemble par la référence 1. Il s'agit de rapporter, sur une semelle inférieure 2 réalisée par exemple en cuivre, des diodes 4 et des IGBT 6 formant un premier arrangement plan de circuit semi-conducteur. Ces diodes 4 et ces IGBT 6 sont assujettis à la semelle 2 de façon connue, au moyen de couches de soudure d'étain-plomb, désignées respectivement par les références 8 et 10. De manière classique, chaque diode 4 est pourvue d'un unique plot de connexion 12 alors que chaque IGBT comprend un plot central 14 et plusieurs plots périphériques 16. Dans l'exemple représenté, la semelle supporte neuf diodes et quatre IGBT, mais l'homme de métier peut faire appel à un nombre différent de tels circuits, en fonctions des caractéristiques qu'il désire conférer au bras d'onduleur définitif.

Puis on emploie une barre conductrice électrique, désignée dans son ensemble par la référence 18, destiné à reposer sur la face libre des plots 12, 14, 16 des circuits semi-conducteurs 4, 6. Cette barre 18 présente une partie d'extrémité amincie 2C et une partie principale 22 plus épaisse, séparées par des épaulements respectivement supérieur 24A et inférieur 24B. Les dimensions de l'épaulement supérieur 24B sont telles que la barre 18 peut reposer sur les circuits 4, 6 selon un plan sensiblement parallèle à celui de la semelle 2.

Des diodes 104 et des IGBT 106 sont disposés sur la face supérieure respective de la partie amincie 20 et de la partie principale 22, de manière à constituer un second arrangement de circuits semi-conducteurs, identique au premier arrangement décrit ci-dessus. Ces diodes 104 et ces IGBT 106 sont assujectis au moyen de couches de soudure respectives 108, 110. Les diodes comportent un plot unique 112, alors que les IGBT sont pourvus d'un plot central 114 et des plots latéraux 116. Les dimensions de l'épaulement supérieur 24A sont telles que les faces supérieures des plots 112, 114, 116 sont disposées sensiblement dans un plan commun, parallèle à celui de la semelle 2.

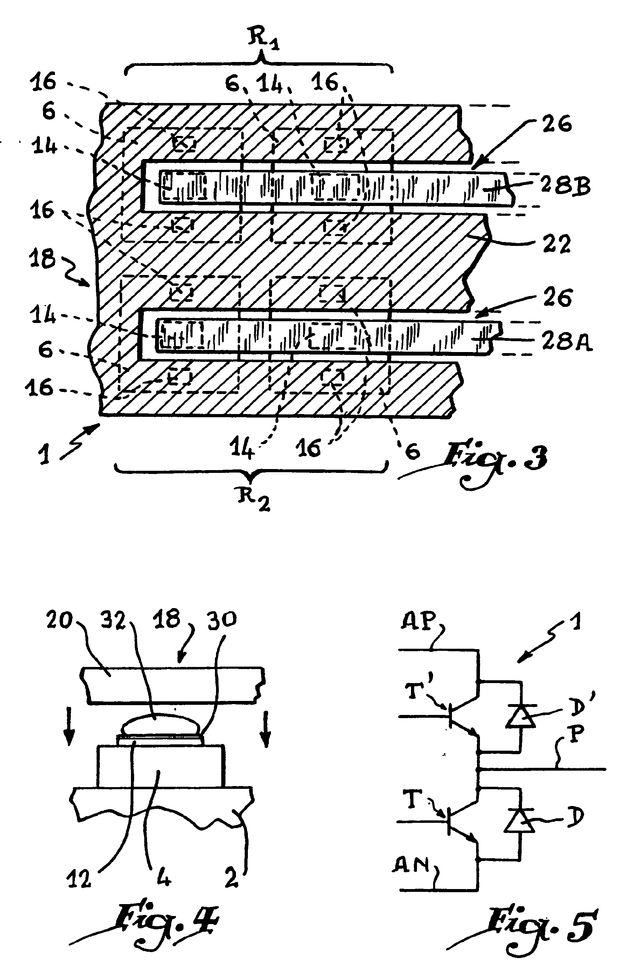

Deux échancrures 26 sont ménagées sur la face inférieure de la partie principale 22 de la barre 18. Ces échancrures 26 sont destinées au passage de deux éléments conducteurs, à savoir des tiges 28A et 28B reliées électriquement entre elles. La première tige 28A est destinée à recouvrir les plots centraux 114 d'une première rangée (R₁) d'IGBT disposés en série, alors que la deuxième tige 28B doit recouvrir les plots centraux de la seconde rangée (R₂) d'IGBT, comme le montre la figure 3. Ces tiges 28A, 28B constituent alors deux grilles permettant de placer en parallèle les deux rangées (R₁, R₂) d'IGBT.

Le pourtour des échancrures 26 de la barre 18 repose, une fois le bras d'onduleur monté, sur les plots latéraux 16 de chaque IGBT 6. Cette barre 18 constitue ainsi un émetteur commun pour l'ensemble de ces IGBT. Il est à noter que les dimensions respectives des échancrures 26 et des tiges 28 sont telles que ces dernières sont isolées électriquement de la barre 18. Ces tiges 28 et la face inférieure de la barre 18 forment donc un réseau plan d'éléments conducteurs isolés entre eux.

On va maintenant décrire, en faisant référence à la figure 4, l'assujettissement de la partie amincie 20 de la barre 18 sur une diode 4 supportée par la semelle 2.

Il s'agit d'abord de revêtir la face libre du plot 12 de la diode 4 au moyen d'un multicouche titane-nickel-or 30, dont l'épaisseur est d'environ 0,8 micromètres et qui est déposé par exemple au moyen d'un procédé de pulvérisation.

Sur ce multicouche 30, on dispose un bossage 32 réalisé en étain-plomb-argent, dont la taille correspond à celle du plot 12. Dans l'exemple considéré, ce bossage a une composition d'environ 2 % d'étain, 95,5 % de plomb et 2,5 % d'argent. Il est à noter que la présence du multicouche 30 confère une excellente tenue mécanique du bossage 32 sur le plot 12.

Il s'agit ensuite de mettre en contact la face inférieure de la partie amincie 20 de la barre 18 avec chaque bossage 32, et d'opérer une fusion de chaque bossage en le chauffant par exemple à environ 330°C pendant 10 secondes. Le plot 12 est alors assujetti à la barre 18.

Dans l'exemple décrit et représenté, il a été uniquement fait allusion à l'assujettissement de la partie amincie 20 de la barre 18 sur un plot 12 d'une diode 4. Bien entendu, l'assujettissement de la partie principale 22 de la barre 18 sur les plots latéraux 16 des IGBT 6, ainsi que celui des tiges 28A et 28B sur les plots centraux 14 des IGBT 6 sont analogues.

La dernière étape de réalisation du bras d'onduleur 1 consiste à rapporter une barre conductrice 34 supplémentaire d'extrémité, opposée à la semelle 2, au-dessus des circuits conducteurs 104, 106 supportés par la barre 18. Cette barre 34 est pourvue d'échancrures 36 propres au passage de tiges conductrices 38A et 38B analogues à celles 28A et 28B décrites précédemment. Ces tiges 38A et 38B, qui sont reliées élastiquement entre elles, constituent des éléments conducteurs supplémentaires d'extrémité, opposées à la semelle 2.

De manière analogue à ce qui a été décrit ci-dessus à propos des circuits 4 et 6, la barre conductrice supplémentaire 34 recouvre, une fois le bras d'onduleur monté, l'ensemble des plots 112 des diodes 104, ainsi que les plots périphériques l16 des IGBT 106. Cette barre 34 assume donc un rôle d'émetteur commun à l'ensemble de ces IGBT. De plus, la première tige supplémentaire 38A recouvre les plots centraux 114 d'une première rangée (R'₁) d'IGBT, alors que la seconde tige supplémentaire 38B est disposée au-dessus des plots centraux de la seconde rangée (R'₂) d'IGBT, de sorte que chacune de ces tiges constitue une grille commune aux IGBT d'une même rangée. Il est à noter que les dimensions respectives des échancrures 36 et des tiges 38 sont telles que la barre 34 et ces tiges 38 ne sont pas en contact mutuel, de manière à constituer un réseau plan d'éléments conducteurs isolés entre eux.

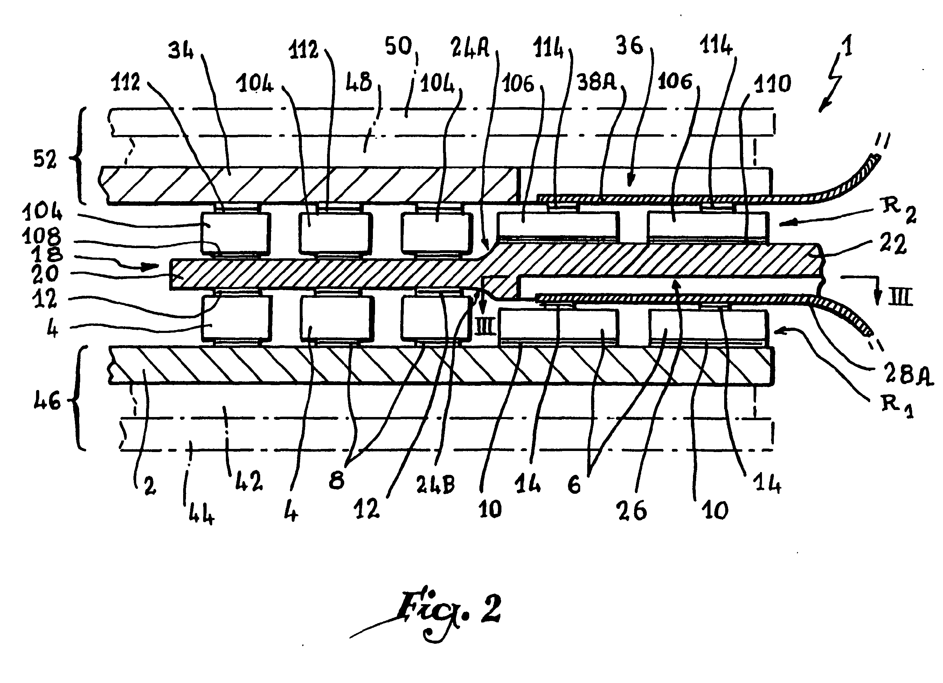

Le schéma électronique de principe du bras d'onduleur 1 est représenté à la figure 5. Par comparaison de cette dernière avec notamment les figures 1 et 2, il apparaît que la semelle 2 forme une alimentation négative AN, et que la barre supplémentaire 34 forme une alimentation positive AP.

L'ensemble des diodes 4 et celui des diodes 104 constituent des diodes équivalentes désignées respectivement par les références D et D' sur la figure 5.

De même, les IGBT 6 et les IGBT 106 réalisent des transistors équivalents désignés respectivement par les références T et T' sur la figure 5. Enfin, la barre conductrice 20 intercalaire forme la phase P de l'onduleur 1.

Le refroidissement du bras d'onduleur une fois assemblé conformément au procédé décrit ci-dessus peut être assuré en l'immergeant dans un fluide diélectrique. La semelle 2 et les barres 18 et 34, qui sont toutes conductrices électriques, assument alors une fonction supplémentaire de dissipation de chaleur.

Il est également envisageable d'inclure la semelle 2 et la barre 34 dans deux structures composites de transfert thermique et d'isolation électrique. A cet effet, on peut disposer, sous la semelle 2, une couche isolante 42 et une couche conductrice 44, toutes deux représentées en traits mixtes, de sorte que la semelle 2 constitue la couche supérieure de la structure 46 ainsi formée. De manière analogue, il est possible de rapporter, au-dessus de la barre conductrice 34, des couches respectivement isolante 48 et conductrice 50, de sorte que la barre 34 constitue la couche inférieure de la structure composite 52 ainsi réalisée.

Le refroidissement du bras d'onduleur 1 est alors assuré en mettant en contact les couches conductrices d'extrémité 44, 50 de ces structures composites 46, 52 avec des éléments de refroidissement non représentés. Ces derniers peuvent être, de manière classique, une plaque à eau, un échangeur de chaleur à air ou encore une buse d'évaporateur "caloduc". Le refroidissement du bras d'onduleur conforme à l'invention est donc opéré à la fois à partir de sa face supérieure et de sa face inférieure.

L'invention permet de réaliser les objectifs précédemment mentionnés. En effet, la structure tri-dimensionnelle du dispositif électronique de puissance conforme à l'invention confère à ce dernier une compacité remarquable. Ceci permet donc, en comparaison des dispositifs de puissance de l'art antérieur, de réduire notablement le volume final du dispositif et de diminuer également les phénomènes d'inductances parasites.

De plus, il est possible, grâce à l'invention, de s'affranchir de l'utilisation des fils d'aluminium employés dans l'art antérieur. Ceci implique donc, outre une simplification de la fabrication, une fiabilité accrue, dans la mesure où ces fils d'aluminium peuvent être à l'origine de graves dysfonctionnements, étant donné qu'ils sont soumis, en service, à des cyclages thermiques à même de provoquer leur rupture.

En outre, en l'absence de ces fils d'aluminium, le dispositif de puissance conforme à l'invention est plus facilement à même d'être refroidi que dans l'art antérieur. En effet, les fils d'aluminium constituent un facteur limitant à l'égard du problème de refroidissement, puisqu'ils s'échauffent de manière proportionnelle au carré du courant qui les traverse, et qu'il se révèle difficile de les refroidir. La dissipation de chaleur garantie par la présence de la semelle et des barres conductrices est à cet égard à mettre en exergue.

L'invention permet donc, du fait de cette amélioration du refroidissement, soit d'augmenter la tenue en courant du dispositif de puissance pour un volume de matériau semi-conducteur utilisé et donc un prix de revient donné, soit de diminuer, pour un courant nominal donné, ce volume et donc le prix de revient global.

L'amélioration du refroidissement est tout particulièrement sensible dans le cas où la semelle conductrice et la barre conductrice qui lui est opposée, appartiennent toutes deux à une structure composite de transfert thermique et d'isolation électrique. Cette conformation assure en effet un double refroidissement simultané de l'ensemble des circuits semi-conducteurs constitutifs du dispositif de puissance, à la fois depuis leurs faces inférieure et supérieure.

## Revendications

1. Dispositif électronique de puissance (1) comprenant :
- une semelle conductrice (2),
- un premier arrangement plan de circuits semi-conducteurs reposant sur la semelle (2), formé par des diodes (4) et des transistors bipolaires à grille isolée dits IGBT (6), lesdits circuits semi-conducteurs (4,6) présentant une face inférieure assujettie à la semelle (2) et une face supérieure pourvue de plots de connexion (12, 14, 16),
- au moins un deuxième arrangement plan de circuits semi-conducteurs (104, 106) au-dessus du premier arrangement plan,
- un réseau plan conducteur (18, 28A, 28B) séparant le premier et le second arrangements plans voisins, ce réseau plan conducteur comprenant :
- au moins une barre (18) conductrice électrique et de dissipation de chaleur reposant sur et connecté à des plots (12, 16) des circuits (4, 6) du premier arrangement, ladite barre (18) supportant en outre, sur sa face opposée à la semelle (2), les circuits (104, 106) du second arrangement plan qui sont assujettis à cette barre (18),
- au moins un élément conducteur (28A, 28B) isolé électriquement de ladite barre (18) étant connecté à d'autres plots (14) des circuits (4, 6) dudit premier arrangement,
**caractérisé en ce que** :
- des échancrures (26) sont ménagées sur la face inférieure de la barre conductrice (18) tournée vers la semelle (2), et
- les éléments conducteurs sont logés à l'intérieur de ces échancrures de manière à être disposés dans le volume de ladite barre.

2. Dispositif selon la revendication 1, **caractérisé en ce que** :
- un arrangement plan de circuits semi-conducteurs (104, 106) d'extrémité au-dessus de tous les autres arrangements plan, est recouvert par un réseau plan conducteur (34, 38A, 38B) d'extrémité, qui comprend au moins une barre d'extrémité (34) conductrice électrique et de dissipation de chaleur reliant des plots (112, 116) des circuits (104, 106) dudit arrangement d'extrémité, et au moins un élément conducteur d'extrémité (38A, 38B) isolé électriquement de ladite barre d'extrémité (34), qui est connecté à d'autres plots (114) des circuits (104, 106) dudit arrangement d'extrémité
- la barre d'extrémité (34) est pourvue d'échancrures propres au passage de l'élément conducteur d'extrémité (38A, 38B), et
- l'élément conducteur d'extrémité (38A, 38B) est logé à l'intérieur de ces échancrures de manière à se trouver disposé dans le volume de la barre d'extrémité (34).

3. Dispositif selon la revendication 1 ou 2, **caractérisé en ce que** les plots (12, 14, 16, 112, 114, 116) desdits arrangements plans (4, 6, 104, 106) sont assujettis respectivement auxdits réseaux plans (18, 28A, 28B, 34, 38A, 38B) par soudure d'au moins un bossage d'étain-plomb-argent (32).

4. Dispositif selon la revendication 3, **caractérisé en ce que** lesdits plots (12, 14, 16, 112, 114, 116) sont séparés du ou de chaque bossage (32) par un revêtement adhérent au ou à chaque bossage, notamment un dépôt de titane-nickel-or (30).

5. Dispositif selon les revendications 1 à 4, **caractérisé en ce que** ladite au moins une barre conductrice (18) comprend au moins un épaulement (24A, 24B) dans une direction perpendiculaire au plan de la semelle de manière à s'étendre globalement dans un plan parallèle à celui de ladite semelle (2).

6. Dispositif selon les revendications 2 à 5, **caractérisé en ce que** ladite semelle (2) et ladite barre (34) d'extrémité appartiennent à des structures composites (46, 52) respectives de transfert thermique et d'isolation électrique.

7. Dispositif selon l'une quelconque des revendications précédentes,
**caractérisé en ce que** :
- des plots de connexion de la face supérieure des circuits semi-conducteurs (4, 6) du premier arrangement sont soudés sur la barre conductrice (18), et
- des faces inférieures des circuits semi-conducteurs (4, 6) du second arrangement plan voisin sont soudées sur cette barre conductrice (18).

8. Dispositif selon les revendications 2 à 7, **caractérisé en ce qu'**il forme un bras d'onduleur (1), et **en ce qu'**il comprend des premier (4, 6) et second (104, 106) arrangements plans identiques, ainsi que des premier (18, 28A, 28B) et second (34, 38A, 38B) réseaux plans conducteurs.

9. Dispositif selon la revendication 8, **caractérisé en ce que** chacun desdits réseaux plans (18, 28A, 28B, 34, 38A, 38B) comprend au moins une grille (28A, 28B, 38A, 38B) commune à une rangée (R1, R2, R'1, R'2) d'IGBT disposés en série.

10. Dispositif selon l'une des revendications 8 ou 9, **caractérisé en ce que** lesdites barres conductrices (18, 34) desdits premier (18, 28A, 28B) et second (34, 38A, 38B) réseaux plans forment des émetteurs communs aux IGBT (6, 106) respectivement desdits premier (4, 6) et second (104, 106) arrangements plans.

## Claims

1. Power semiconductor device (1) comprising:
- a conductive base (2)
- a first planar arrangement of semiconductor circuits situated on the base (2), formed by diodes (4) and insulated gate bipolar transistors termed IGBT (6), said semiconductor circuits (4, 6) having a lower face which is secured to the base (2) and an upper face which is provided with connection terminals (12, 14, 16),
- at least one second planar arrangement of semiconductor circuits (104, 106) above the first planar arrangement,
- a planar conductive network (18, 28A, 28B) which separates the first and the second adjacent planar arrangements, this planar conductive network comprising:
- at least one electrically conductive bar (18) for dissipating heat, which bar is situated on and connected to terminals (12, 16) of circuits (4, 6) of the first arrangement, said bar (18) supporting furthermore, on the face thereof opposite the base (2), the circuits (104, 106) of the second planar arrangement which are secured to this bar (18),
- at least one conductive element (28A, 28B), which is insulated electrically from said bar (18), being connected to other terminals (14) of circuits (4, 6) of said first arrangement,
**characterised in that**:
- notches (26) are provided on the lower face of the conductive bar (18) which is turned towards the base (2), and
- the conductive elements are accommodated inside these notches so as to be disposed in the volume of said bar.

2. Device according to claim 1, **characterised in that**:
- an end, planar arrangement of semiconductor circuits (104, 106) above all the other planar arrangements is covered by an end planar conductive network (34, 38A, 38B) which comprises at least one electrically conductive end bar (34) for dissipating heat, which bar connects terminals (112, 116) of circuits (104, 106) of said end arrangement, and at least one end conductive element (38A, 38B) which is insulated electrically from said end bar (34) and is connected to other terminals (114) of circuits (104, 106) of said end arrangement,
- the end bar (34) is provided with notches suitable for passage of the end conductive element (38A, 38B), and
- the end conductive element (38A, 38B) is accommodated inside these notches so as to be disposed in the volume of the end bar (34).

3. Device according to claim 1 or 2, **characterised in that** the terminals (12, 14, 16, 112, 114, 116) of said planar arrangements (4, 6, 104, 106) are secured respectively to said planar networks (18, 28A, 28B, 34, 38A, 38B) by welding of at least one tin-lead-silver boss (32).

4. Device according to claim 3, **characterised in that** said terminals (12, 14, 16, 112, 114, 116) are separated from the or from each boss (32) by a coating which adheres to the or to each boss, in particular a titanium-nickel-gold deposit (30).

5. Device according to claims 1 to 4, **characterised in that** said at least one conductive bar (18) comprises at least one shoulder (24A, 24B) in a direction perpendicular to the plane of the base so as to extend overall in a plane which is parallel to that of said base (2).

6. Device according to claims 2 to 5, **characterised in that** said base (2) and said end bar (34) are associated with respective composite structures (46, 52) for thermal transfer and electrical insulation.

7. Device according to any-of the preceding claims, **characterised in that**:
- connection terminals of the upper face of semiconductor circuits (4, 6) of the first arrangement are welded on the conductive bar (18), and
- lower faces of semiconductor circuits (4, 6) of the adjacent second planar arrangement are welded on this conductive bar (18).

8. Device according to claims 2 to 7, **characterised in that** it forms an inverter arm (1), and **in that** it comprises first (4, 6) and second (104, 106) identical planar arrangements and also first (18, 28A, 28B) and second (34, 38A, 38B) planar conductive networks.

9. Device according to claim 8, **characterised in that** each of said planar networks (18, 28A, 28B, 34, 38A, 38B) comprises at least one gate (28A, 28B, 38A, 38B) which is common to a row (R1, R2, R'1, R'2) of IGBT disposed in series.

10. Device according to one of the claims 8 or 9, **characterised in that** said conductive bars (18, 34) of said first (18, 28A, 28B) and second (34, 38A, 38B) planar networks form transmitters which are common to the IGBT (6, 106) respectively of said first (4, 6) and second (104, 106) planar arrangements.

## Patentansprüche

1. Leistungselektronikvorrichtung (1), aufweisend:
- eine Leiterplatte (2),
- eine erste flächige Anordnung von Halbleiterschaltkreisen, die auf der Platte (2) angeordnet sind, gebildet von Dioden (4) und Bipolartransistoren mit isolierter Gateelektrode, sog. IGBTs (6), wobei die Halbleiterschaltkreise (4, 6) eine untere Seite aufweisen, die an der Platte (2) befestigt ist, und eine obere Seite, die mit Verbindungsstiften (12, 14, 16) versehen ist,
- zumindest eine zweite flächige Anordnung von Halbleiterschaltkreisen (104, 106) oberhalb der ersten flächigen Anordnung,
- ein flächiges Leiterbild (18, 28A, 28B), das die erste und zweite benachbarte Anordnung trennt, wobei dieses flächige Leiterbild enthält:
- zumindest eine wärmeableitende Stromschiene (18), die auf Stiften (12, 16) der Schaltkreise (4, 6) der ersten Anordnung aufliegt und mit diesen verbunden ist, wobei die Schiene (18) auf ihrer der Platte (2) entgegengesetzten Seite ferner die Schaltkreise (104, 106) der zweiten flächigen Anordnung trägt, die an dieser Schiene (18) befestigt sind,
- zumindest ein von der Schiene (18) elektrisch isoliertes Leiterelement (28A, 28B), das mit anderen Stiften (14) der Schaltkreise (4, 6) der ersten Anordnung verbunden ist,
**dadurch gekennzeichnet, dass**
- Aussparungen (26) an der unteren Seite der Stromschiene (18), die in Richtung der Platte (2) gerichtet ist, vorgesehen sind, und
- die Leiterelemente im Innern dieser Aussparungen derart untergebracht sind, dass sie in dem Volumen der Schiene angeordnet sind.

2. Vorrichtung nach Anspruch 1, **dadurch gekennzeichnet, dass**
- eine abschließende flächige Anordnung von Halbleiterschaltkreisen (104, 106) oberhalb aller anderen flächigen Anordnungen von einem abschließenden flächigen Leiterbild (34, 38A, 38B) bedeckt ist, das zumindest eine abschließende wärmeableitende Stromschiene (34) aufweist, welche die Stifte (112, 116) der Schaltkreise (104, 106) der abschließenden Anordnung verbindet, und zumindest ein abschließendes von der abschließenden Schiene (34) elektrisch isoliertes Leiterelement (38A, 38B), das mit anderen Stiften (114) der Schaltkreise (104, 106) der abschließenden Anordnung verbunden ist,
- die abschließende Schiene (34) mit Aussparungen für den Durchtritt des abschließenden Leiterelements (38A, 38B) versehen ist, und
- das abschließende Leiterelement (38A, 38B) im Innern dieser Aussparungen derart untergebracht ist, dass es sich in dem Volumen der abschließenden Schiene (34) angeordnet befindet.

3. Vorrichtung nach Anspruch 1 oder 2, **dadurch gekennzeichnet, dass** die Stifte (12, 14, 16, 112, 114, 116) der flächigen Anordnungen (4, 6, 104, 106) jeweils an den flächigen Bildern (18, 28A, 28B, 34, 38A, 38B) durch Löten mindestens eines Höckers (32) aus Zinn-Blei-Silber befestigt sind.

4. Vorrichtung nach Anspruch 3, **dadurch gekennzeichnet, dass** die Stifte (12, 14, 16, 112, 114, 116) von dem oder von jedem Höcker (32) durch eine dem oder jedem Höcker anhaftende Beschichtung, insbesondere einen Überzug (30) aus Titan-Nickel-Gold, getrennt sind.

5. Vorrichtung nach den Ansprüchen 1 bis 4, **dadurch gekennzeichnet, dass** die zumindest eine Stromschiene (18) zumindest einen Absatz (24A, 24B) in einer zu der Ebene der Platte senkrechten Richtung aufweist, derart, dass er sich im Wesentlichen in einer zu der Ebene der Platte (2) parallelen Ebene erstreckt.

6. Vorrichtung nach den Ansprüchen 2 bis 5, **dadurch gekennzeichnet, dass** die Platte (2) und die abschließende Schiene (34) jeweiligen wärmeübertragenden und elektrisch isolierenden Verbundstrukturen (46, 52) zugehörig sind.

7. Vorrichtung nach einem der vorangehenden Ansprüche, **dadurch gekennzeichnet, dass**
- Verbindungsstifte der oberen Seite der Halbleiterschaltkreise (4, 6) der ersten Anordnung auf der Stromschiene (18) verlötet sind und
- untere Seiten der Halbleiterschaltkreise (4, 6) der zweiten benachbarten flächigen Anordnung auf dieser Stromschiene (18) verlötet sind (18).

8. Vorrichtung nach den Ansprüchen 2 bis 7, **dadurch gekennzeichnet, dass** sie einen Wechselrichtersatz bildet (1) und dass sie eine identische erste (4, 6) und zweite (104, 106) flächige Anordnung sowie ein erstes (18, 28A, 28B) und zweites (34, 38A, 38B) flächiges Leiterbild aufweist.

9. Vorrichtung nach Anspruch 8, **dadurch gekennzeichnet, dass** jedes der flächigen Bilder (18, 28A, 28B, 34, 38A, 38B) zumindest ein Gate (28A, 28B, 38A, 38B) aufweist, das einer Reihe (R1, R2, R'1, R'2) von in Reihe angeordneten IGBTs gemeinsam ist.

10. Vorrichtung nach einem der Ansprüche 8 oder 9, **dadurch gekennzeichnet, dass** die Stromschienen (18, 34) des ersten (18, 28A, 28B) und zweiten (34, 38A, 38B) flächigen Bildes Emitter aufweisen, die den IGBTs (6, 106) der ersten (4, 6) bzw. der zweiten (104, 106) flächigen Anordnung gemeinsam sind.
